(19) Europäisches Patentamt / European Patent Office / Office européen des brevets

(11) EP 3 074 820 B1

(12) EUROPEAN PATENT SPECIFICATION

(45) Date of publication and mention
of the grant of the patent:
**20.09.2017 Bulletin 2017/38**

(21) Application number: **14806552.7**

(22) Date of filing: **14.11.2014**

(51) Int Cl.:
*G03F 7/20* (2006.01)    *G01B 11/03* (2006.01)
*H05G 2/00* (2006.01)    *G01P 3/68* (2006.01)

(86) International application number:
**PCT/EP2014/074576**

(87) International publication number:
**WO 2015/078705 (04.06.2015 Gazette 2015/22)**

(54) **MEASURING ARRANGEMENT FOR USE WHEN DETERMINING TRAJECTORIES OF FLYING OBJECTS**

MESSANORDNUNG ZUR BESTIMMUNG DER FLUGBAHNEN VON FLIEGENDEN OBJEKTEN

DISPOSITIF DE MESURE À UTILISER LORS DE LA DÉTERMINATION DES TRAJECTOIRES D'OBJETS VOLANTS

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **29.11.2013 DE 102013224583**

(43) Date of publication of application:
**05.10.2016 Bulletin 2016/40**

(73) Proprietor: **Carl Zeiss SMT GmbH**
**73447 Oberkochen (DE)**

(72) Inventor: **MANGER, Matthias**
**73432 Aalen-Unterkochen (DE)**

(74) Representative: **Frank, Hartmut**
**Bonsmann Bonsmann Frank**
**Patentanwälte**
**Reichspräsidentenstraße 21-25**
**45470 Mülheim a. d. Ruhr (DE)**

(56) References cited:
**DE-A1-102012 006 529**    **US-A1- 2010 258 747**
**US-A1- 2012 104 289**

**EP 3 074 820 B1**

**Description**

BACKGROUND OF THE INVENTION

Field of the invention

The invention relates to a measuring arrangement for use when determining trajectories of flying objects.
Even though the invention is suitable in particular for measuring and predicting the flight trajectory of target droplets (e.g. tin droplets) in laser plasma sources such as, for instance, in an EUV source of a microlithographic projection exposure apparatus, the invention is not restricted thereto. In further applications, the measuring arrangement according to the present invention is also generally suitable for observing rapidly flying objects (e.g. under a microscope) or generally for observing the flight trajectory of rapidly flying projectiles.

Prior art

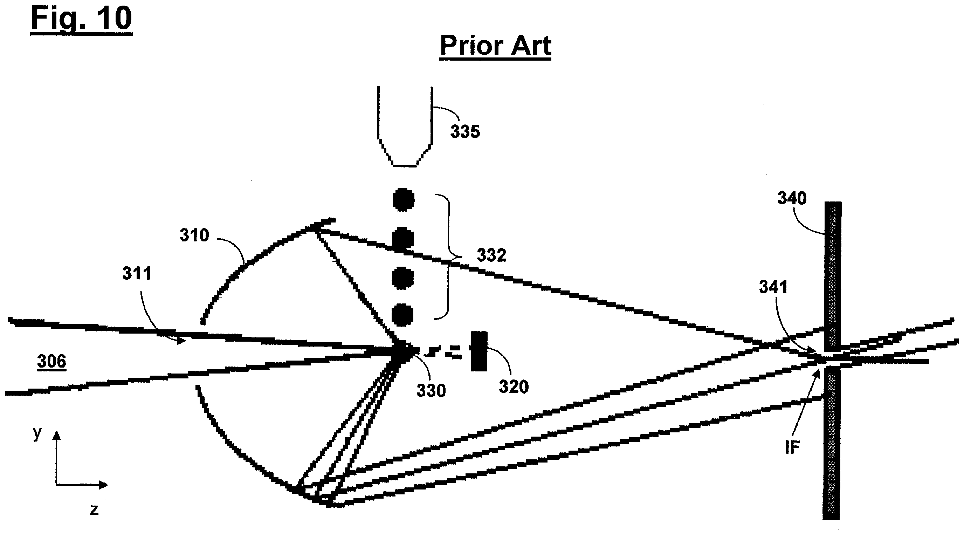

By way of example, the use of high-speed cameras is known for observing the flight trajectory of rapidly flying projectiles. However, limits are imposed on this approach in the case of objects flying in at a high repetition rate, as is the case for instance in the application in a laser plasma source as explained below.
Laser plasma sources are used e.g. for application in lithography. In this regard, for instance, during the operation of a projection exposure apparatus designed for the EUV range (e.g. at wavelengths of e.g. approximately 13 nm or approximately 7 nm), the required EUV light is generated by means of an EUV light source based on a plasma excitation, with respect to which Figure 10 shows an exemplary conventional construction. This EUV light source firstly comprises a $CO_2$ laser (not shown) for generating infrared radiation 306 having a wavelength of $\lambda \approx 10.6\ \mu m$, which is focussed by means of a focussing optical unit, passes through an opening 311 present in a collector mirror 310 embodied as an ellipsoid and is directed onto a target material 332 (e.g. tin droplet) that is generated by means of a target source 335 and is fed to a plasma ignition position 330. The infrared radiation 306 heats the target material 332 situated in the plasma ignition position 330 in such a way that said target material undergoes transition to a plasma state and emits EUV radiation. This EUV radiation is focussed onto an intermediate focus IF by means of the collector mirror 310 and passes through said intermediate focus into a downstream illumination device, the boundary 340 of which is merely indicated and which has a free opening 341 for the entrance of light.
What is of major importance for the dose stability and power that can be obtained in an EUV light source in this case is that the tin droplets "flying in" very rapidly (e.g. with an injection rate in the region of 100 kHz or with a temporal spacing of e.g. 10 $\mu s$) into the laser plasma source as the light demand increases are struck individually highly accurately (with an accuracy of e.g. below 1 $\mu m$) and reproducibly by the laser beam that atomizes the droplet. One problem that occurs here is that the conversion of a droplet to a plasma is accompanied in each case by a reaction on the rest of the droplets or a deflection of the rest of the droplets which are already situated in the feed path, which makes it more difficult to carry out an exact prediction of the flight trajectory and, if appropriate, to implement suitable measures for influencing
US 2010/258747 A1 relates to EUV lithography and discloses a measuring arrangement comprising one or more droplet imagers e.g., system(s) for capturing images using CCD's and/ or backlight stroboscopic illumination and/or light curtains that provide an output indicative of the position and/or timing of one or more droplets, e.g., relative to an irradiation region.
US 2012/104289 relates to EUV lithography and discloses a droplet control device comprising at least one droplet sensor including a magnetic circuit including a coil configured of an electrically conductive material, and a current detection unit for detecting current flowing in the coil and outputting a detection signal; a signal processing circuit for detecting the charged droplet based on the detection signal from the droplet sensor; and a trajectory control unit for controlling a trajectory of the charged droplet.
DE 10 2012 006529 A1 relates to field of detecting a flying projectile and discloses a device comprising a light source that illuminates an objective plane in one or two dimensionally over the entire surface, for formation of light field. The light source is provided for partially or completely imaging punctiform detectors, during one-dimensional light field or two-dimensional light field. The detectors are provided for detecting segments of the light field, such that the shadow formed in respective dimensional light field is detected by flying projectile.

SUMMARY OF THE INVENTION

It is an object of the present invention to provide a measuring arrangement for use when determining trajectories of flying objects which enables the flight trajectory to be determined and predicted as accurately and promptly as possible even in the case of objects flying in at high frequency, such as e.g. target droplets in a laser plasma source for EUV lithography.

This object is achieved by means of the measuring arrangement according to the features of independent Claim 1.

A measuring arrangement according to the invention for use when determining trajectories of flying objects comprises:

- at least one photodetector arrangement comprising a plurality of photodetector cells in a monolithic construction;

- wherein said photodetector arrangement is assigned exactly one imaging system, which, during the operation of the measuring arrangement, images in each case a flying object situated in an object plane of the imaging system onto the photodetector arrangement situated in an image plane of the imaging system; and

- a time measuring device for measuring transit instants, wherein each of said transit instants corresponds to an instant at which an image of a flying object, said image being generated in the image plane of the imaging system, in each case crosses a cell boundary between mutually adjacent photodetector cells in the photodetector arrangement.

In this case, although the basic principle of determining trajectories on the basis of the measurement of transit instants itself forms the starting point for the concept underlying the present invention, it does not per se belong to the claimed subject matter of the present application. Rather, the invention is based on the concept of providing an optoelectronic realization for measuring flight trajectories or determining trajectories by a flying object being imaged by means of an imaging system (in the object plane of which the object is situated) onto a suitably configured photodetector arrangement embodied in a monolithic fashion, wherein imaginary target lines are defined or embodied optoelectronically by the cell boundaries between mutually adjacent photodetector cells and wherein the crossing of said target lines (i.e. the transit instants at which the crossing takes place in each case) is measurable using suitable electronic switching elements.

In this case, the invention is distinguished, in particular, by the fact that owing to the circumstance that only transmit times with regard to the crossing of target lines suitably defined previously (that is to say start and stop times) have to be evaluated for the purpose of measuring flight trajectories, the required items of information are present in each case directly with respect to time, without for instance firstly the need to carry out or await a comparatively time-consuming image evaluation as in the case when high-speed cameras are used. As a result, it is thus possible to achieve an accurate and prompt determination and prediction of the flight trajectory at very high repetition rates (e.g. in the range of from 10 kHz to more than 100 kHz) and with a very low "data age" (e.g. far less than 10 $\mu s$).

Even though the invention is suitable in particular for measuring and predicting flight trajectories of target droplets (e.g. tin droplets) in laser plasma sources, such as, for instance, in an EUV source of a microlithographic projection exposure apparatus, the invention is not restricted thereto. In further applications, the sensor arrangement according to the present invention is also generally suitable for observing rapidly flying objects e.g. under a microscope or generally for observing the flight trajectory of rapidly flying projectiles.

In accordance with one embodiment, the imaging system is configured as a replicating imaging system which generates at least two images of the object in the image plane. This makes possible, as described in even more detail below, the use of a photodetector arrangement which is constructed in a "folded" manner (in which the individual photodetector cells are arranged non-linearly) and which allows a shortening of the required measurement section or a reduction of the image field extent in the imaging system according to the invention in comparison with an "unfolded" photodetector arrangement (having a linear arrangement of the individual photodetector cells), that is to say overall a "relaxation" of the requirements made of the imaging system.

Depending on the existing size ratios or accuracy requirements, the imaging system can be configured in a magnifying or else reducing fashion.

In accordance with one embodiment, the imaging system has at least one diffractive structure, which is preferably arranged in a pupil plane of the imaging system. During the operation of the measuring arrangement with monochromatic light, this enables a replication of the imaging beam path for the use of a photodetector arrangement constructed in a "folded" manner.

In accordance with one embodiment, the imaging system has at least one optical beam splitter. During the operation of the measuring arrangement with polychromatic light, too, this enables a replication of the imaging beam path for the use of a photodetector arrangement constructed in a "folded" manner.

In accordance with one embodiment, the imaging system has at least one intermediate image. The corresponding intermediate image plane can be used to suppress undesired parasitic light and disturbing reflections with the aid of a stop.

In accordance with one embodiment, the photodetector cells are configured as photodiodes. However, the invention is not restricted thereto, and so other photodetectors, such as e.g. photoresistors, can also be used in further embodiments.

In accordance with one embodiment, the photodetector arrangement is configured in such a way that at least one cell boundary between mutually adjacent photodetector cells runs at an angle of $45° \pm 5°$ with respect to a centroid trajectory of the flying object. Furthermore, the photodetector arrangement can be configured in such a way that a first cell boundary between mutually adjacent photodetector cells and at least a second cell boundary between mutually adjacent photodetector cells run parallel to one another. Such configuration of the cell boundaries in the photodetector arrangement used according to the invention makes it possible, as explained in even greater detail below, to obtain as it were an optimization of the mathematical definiteness or determinability of the set of parameters describing the flight trajectory or trajectory.

In further embodiments of the invention, the (transit time) information of cell boundaries or target lines which are actually redundant (i.e. which are not necessarily required or are "surplus" per se for determining the set of parameters describing the trajectory) can also be used to obtain an increased accuracy of the measurement.

In accordance with one embodiment, the measuring arrangement is integrated into a control loop for controlling the trajectories of flying objects, for controlling a radiation field acting on the objects and/or for controlling an entity acting on the objects (e.g. a material-processing laser beam). The information obtained about the flight trajectory can thus be used, for example, to have a correcting influence on the object itself (e.g. in a laser plasma source the target droplets or tin droplets to be struck) or an entity acting on the objects.

In accordance with one embodiment, the measuring arrangement furthermore comprises at least one camera in the imaging beam path of the imaging system. Such a camera, which can be equipped e.g. with a pixelated 2D image sensor, can serve in particular for supporting the alignment or for diagnosis purposes.

In accordance with one embodiment, the measuring arrangement comprises at least two imaging systems, wherein a photodetector arrangement comprising in each case a plurality of photodetector cells in a monolithic construction is in each case arranged in the image plane of each of said imaging systems. In this way, the trajectory to be measured of the flying object can be observed at mutually different angles, with the consequence that the complete three-dimensional trajectory can also be ascertained from the two-dimensional trajectories (or projections) respectively obtained.

In accordance with one embodiment, the measuring arrangement is configured for use when determining trajectories of target droplets of a laser plasma source, in particular of an EUV source of a microlithographic projection exposure apparatus.

Further configurations of the invention can be gathered from the description and the dependent claims.

The invention is explained in greater detail below on the basis of exemplary embodiments illustrated in the accompanying figures.

## BRIEF DESCRIPTION OF THE DRAWINGS

In the figures:

Figure 1  shows a schematic illustration for elucidating the principle forming a starting point for the present invention;

Figures 2a-d  show schematic illustrations for elucidating an optoelectronic embodiment of a target line that is realized in the context of the present invention;

Figure 3  shows a schematic illustration for elucidating a time-of-flight measurement effected in the context of the present invention in accordance with one possible embodiment;

Figures 4a-b  show schematic illustrations for elucidating possible embodiments of a photodetector arrangement comprising in each case a plurality of photodetector cells;

Figures 5a-b  show a schematic illustration for elucidating further possible embodiments of a photodetector arrangement and possible folding schemes with regard to the arrangement of photodetector cells;

Figures 6a-d  show schematic illustrations for elucidating different target line configurations and the assessment thereof;

Figures 7a-b  show schematic illustrations in each case of a possible imaging beam path realized within a measuring arrangement according to the invention;

Figures 8-9   show schematic illustrations in each case of a possible construction of an imaging system and the arrangement thereof within a measuring arrangement according to the invention; and

Figure 10   shows a schematic illustration of the construction of an EUV light source in accordance with the prior art.

DETAILED DESCRIPTION OF PREFERRED EMBODIMENTS

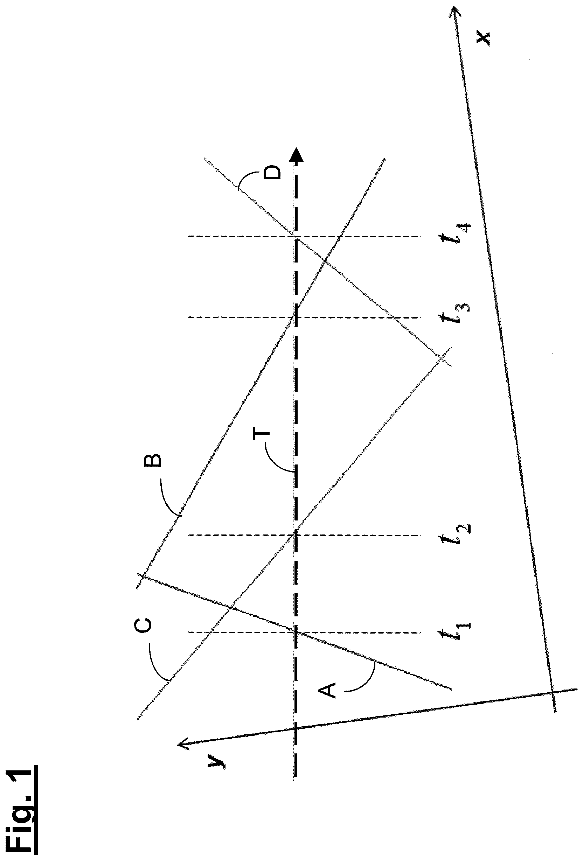

The realization according to the invention of a measuring arrangement for use when determining trajectories of flying objects is based on the principle that a trajectory determination, i.e. the determination of the flight trajectory parameters of a flying object, can be carried out on the basis of the measurement of transit instants concerning the crossing of defined target lines. In this case, each of said transit instants is assigned to a target line from a plurality of target lines and corresponds to that instant at which a flying object in each case crosses said target line. Fig. 1 serves to illustrate this principle, wherein the object's flight trajectory that is to be detected metrologically is designated by "T" and wherein merely by way of example four target lines "A"-"D" are depicted in Fig. 1, wherein the transit instants at which the respective target line is crossed by the object are designated by "$t_1$"-"$t_4$". With knowledge of the geometry of the target lines, the flight trajectory parameters can then be calculated on the basis of the measured transit times "$t_1$"-"$t_4$", as described below.

The mathematical foundations underlying this principle will firstly be explained below. A linear three-dimensional flight trajectory of a flying object or projectile can basically be described by the equation

$$\begin{pmatrix} X(t) \\ Y(t) \\ Z(t) \end{pmatrix} = \begin{pmatrix} X_0 \\ Y_0 \\ Z_0 \end{pmatrix} + \left(t - t_0\right)\begin{pmatrix} U \\ V \\ W \end{pmatrix} \qquad (1)$$

wherein $X(t), Y(t), Z(t)$ denote the position coordinates at the time $t$, $X_0, Y_0, Z_0$ denote the position coordinates at the time $t_0$ and $U, V, W$ denote the velocity components. If - as described in even greater detail below in association with the embodiments of the invention - an imaging system is then used to image the flying object situated in an object plane of the imaging system into an image plane, this imaging onto the image plane given the image distance B can be described using the intercept theorem by:

$$\begin{pmatrix} x(t) \\ y(t) \end{pmatrix} = \frac{-B}{Z(t)}\begin{pmatrix} X(t) \\ Y(t) \end{pmatrix} = \frac{-B}{Z_0 + \left(t - t_0\right)W}\begin{pmatrix} X_0 + \left(t - t_0\right)U \\ Y_0 + \left(t - t_0\right)V \end{pmatrix} \qquad (2)$$

If an orientation of the flight trajectory that is perpendicular to the optical axis (z-axis) is taken as a basis, then $W = 0$ holds true for the velocity component W in the z-direction, and equation (2) is simplified as

$$\begin{pmatrix} x(t) \\ y(t) \end{pmatrix} = \frac{-B}{Z_0}\begin{pmatrix} X_0 + \left(t - t_0\right)U \\ Y_0 + \left(t - t_0\right)V \end{pmatrix} = \begin{pmatrix} x_0 + \left(t - t_0\right)u \\ y_0 + \left(t - t_0\right)v \end{pmatrix} \qquad (3)$$

with the abbreviations $\begin{pmatrix} x_0 \\ y_0 \end{pmatrix} = M\begin{pmatrix} X_0 \\ Y_0 \end{pmatrix}$ and $\begin{pmatrix} u \\ v \end{pmatrix} = M\begin{pmatrix} U \\ V \end{pmatrix}$ and the imaging scale $M = \dfrac{-B}{Z_0}$.

The flight trajectory of the object is then determined according to the invention by way of a metrological determination of the set of parameters of the projected flight trajectory which includes the two location point position coordinates $x_0$ and $y_0$ and the two velocity components $u$ and $v$. In order to determine these four unknown flight trajectory parameters, it is necessary to define at least four of such target lines in a suitable configuration. For the mathematical description, firstly a dedicated reference coordinate system is introduced for each target line $k = 1,...,K$, said system arising as a result of the rotation of the original coordinate axes by a rotation angle $\theta_k$. The flight trajectory description in the respective coordinate system then reads

$$\begin{pmatrix} x_k(t) \\ y_k(t) \end{pmatrix} = \begin{pmatrix} cs_k & -sn_k \\ sn_k & cs_k \end{pmatrix} \begin{pmatrix} x_0 + (t - t_0)u \\ y_0 + (t - t_0)v \end{pmatrix} \qquad (4)$$

with the abbreviations $cs_k = \cos(\theta_k)$ and $sn_k = \sin(\theta_k)$. The corresponding transformation for the coordinate axes is given by

$$\begin{pmatrix} \hat{x}_k \\ \hat{y}_k \end{pmatrix} = \begin{pmatrix} cs_k & sn_k \\ -sn_k & cs_k \end{pmatrix} \begin{pmatrix} \hat{x} \\ \hat{y} \end{pmatrix} \qquad (5).$$

Hereinafter, without any restriction of the generality, a target line is defined as a straight line which is parallel to the rotated $y_k$-axis and which intersects the rotated $x_k$-axis at the position $x_k$. For the crossing of the target line (i.e. the "target line transit") there follows from equation (4) after suitable transformation the relationship

$$x_k = \begin{pmatrix} cs_k & -sn_k & cs_k(t_k - t_0) & -sn_k(t_k - t_0) \end{pmatrix} \begin{pmatrix} x_0 \\ y_0 \\ u \\ v \end{pmatrix} \qquad (6)$$

Stacking at least four of such equations results in the following conditional equation for the flight trajectory parameters

$$\begin{pmatrix} x_1 \\ x_2 \\ \vdots \\ x_K \end{pmatrix} = \underbrace{\begin{pmatrix} cs_1 & -sn_1 & cs_1(t_1 - t_0) & -sn_1(t_1 - t_0) \\ cs_2 & -sn_2 & cs_2(t_2 - t_0) & -sn_2(t_2 - t_0) \\ \vdots & & & \\ cs_K & -sn_K & cs_K(t_K - t_0) & -sn_K(t_K - t_0) \end{pmatrix}}_{\underline{M}} \begin{pmatrix} x_0 \\ y_0 \\ u \\ v \end{pmatrix} \qquad (7)$$

With knowledge of the geometry and the transit times, the flight trajectory parameters sought are finally obtained therefrom, by means of inversion of the design matrix $\underline{M}$, as

$$\begin{pmatrix} x_0 \\ y_0 \\ u \\ v \end{pmatrix} = inv\left(\underline{M}^T \underline{M}\right)\underline{M}^T \begin{pmatrix} x_1 \\ x_2 \\ \vdots \\ x_K \end{pmatrix} \qquad (8)$$

Proceeding from the above mathematical considerations and equations obtained, an optoelectronic realization of the flight trajectory measurement or trajectory determination is then carried out according to the invention by virtue of the fact that the respective object to be measured in terms of its flight trajectory is imaged onto a suitably configured photodetector arrangement by means of an imaging system (in the object plane of which the object is situated). In this case, precisely the target lines described above are defined or optoelectronically embodied by the cell boundaries between mutually adjacent photodetector cells, and the crossing of said target lines (i.e. the transit times) becomes directly measurable using suitable electronic switching elements.

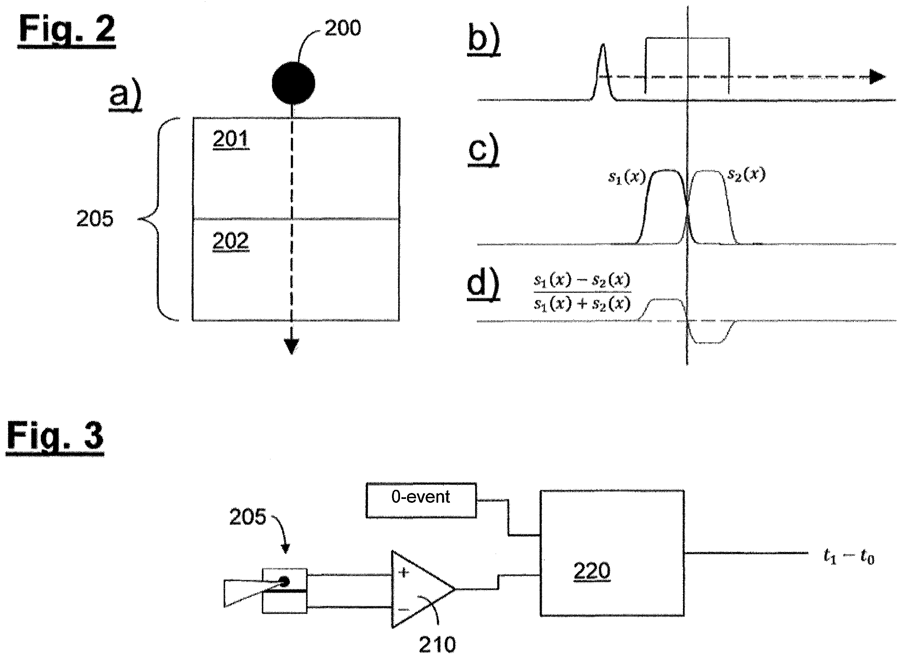

The optoelectronic realization or embodiment of the target lines described above is firstly explained below with reference to Fig. 2-4.

Fig. 2a schematically indicates how a light spot 200 proceeding from a flying object successively passes through a first optoelectronic sensor in the form of a first photodiode 201 and a second optoelectronic sensor in the form of a second photodiode 202. Fig. 2b indicates an energy distribution which corresponds to the light spot 200 and is modelled as Gaussian, and the respective sensor signals $s_1(x)$ and $s_2(x)$ of the photodiodes 201, 202 are plotted in Fig. 2c. For the difference signal $((s_1(x)-s_2(x))/s_1(x)+s_2(x))$ normalized to the total intensity and plotted in Fig. 2d, a zero crossing arises at the transition between the two photodiodes 201, 202. A target line can then be defined by said transition, wherein a circuitry realization for generating a trigger signal upon said target line being crossed is illustrated schematically in Fig. 3. As a "transit detector" for the crossing of the target line, use is made here of a Schmitt trigger 210, which, for a connected TDC component 220, generates a start/stop trigger signal that is sufficiently precise in so far as resolutions of the (flight) time measurement in the range of 100 ps can be realized here.

Proceeding from the optoelectronic realization of an individual target line as described above with reference to Fig. 2 and 3, the realization of a desired target line configuration (containing a number k of target lines) is then effected according to the invention by the provision of a monolithically embodied photodetector arrangement having a plurality of photodetector cells in a geometry coordinated with the target line configuration. An imaging system is used in conjunction with said photodetector arrangement, as explained in even greater detail below, and the photodetector arrangement is arranged in an image plane of the imaging system, such that the flying object situated in an object plane of the imaging system is imaged onto the photodetector arrangement situated in the image plane.

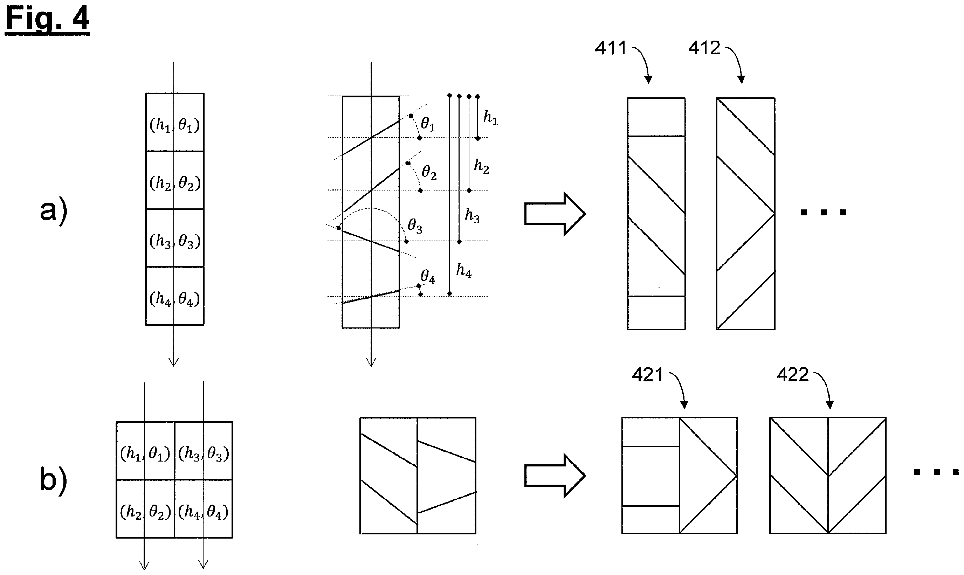

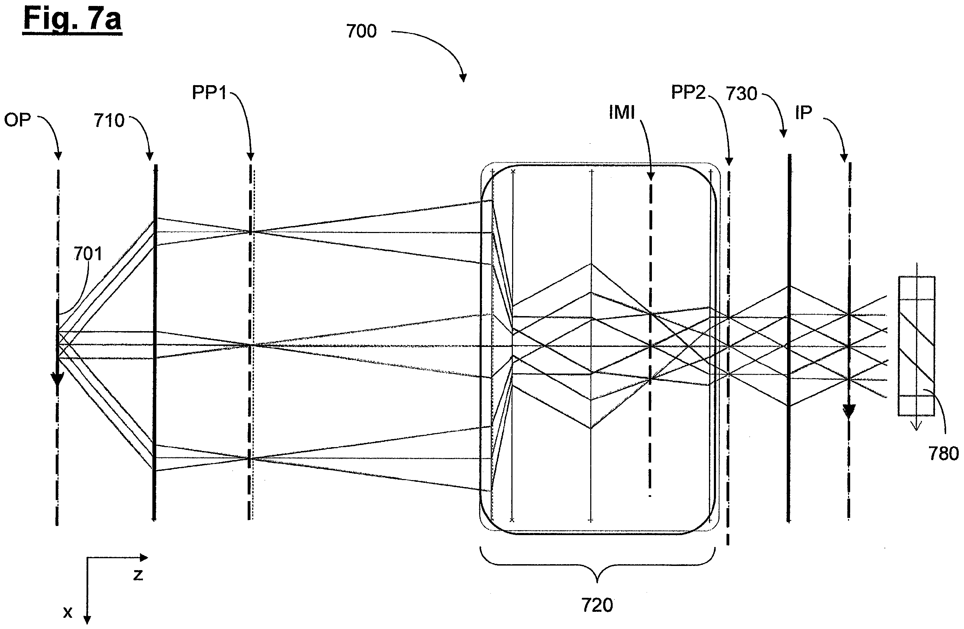

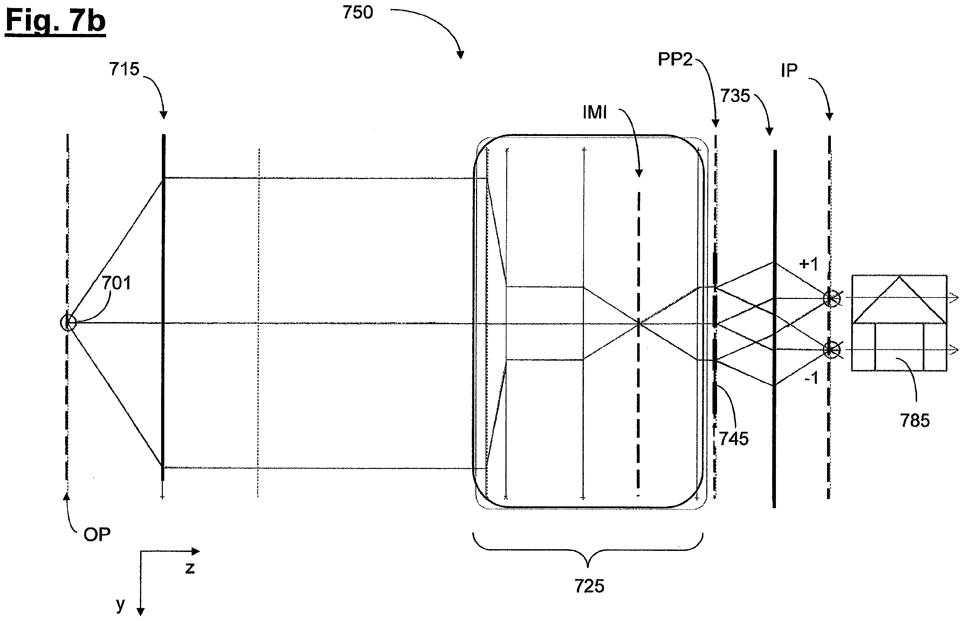

Said imaging system will be discussed in even greater detail with reference to Fig. 7-9. As far as, firstly, the abovementioned target line configuration is concerned, the latter comprises a set of target lines $\{(h_k, \theta_k), k = 1, ..., K\}$ which are parameterized by their spacing $h_k$, and their orientation angle $\theta_k$, as is illustrated by way of example in Fig. 4a and Fig. 4b for four target lines in each case.

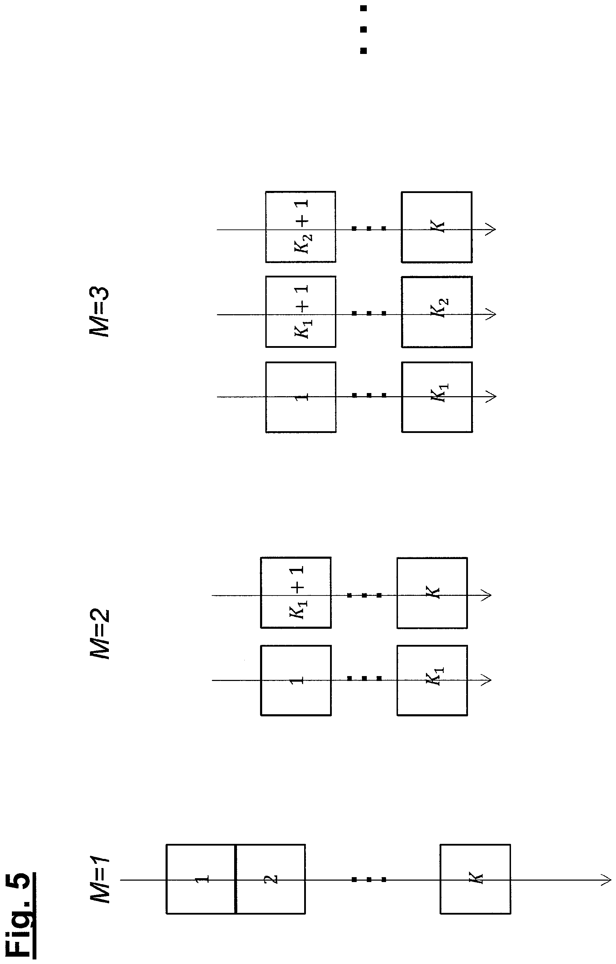

Fig. 4a shows the construction of photodetector arrangements 411, 412,... having a linear arrangement of the photodetector cells, for which only a simple (i.e. non-replicating) optical imaging of the flying object onto the photodetector arrangement is required. By contrast, Fig. 4b shows the construction of photodetector arrangements 421, 422,... having a folded arrangement of the photodetector cells, for which an optically replicating imaging is required. The folded arrangements in Fig. 4b are advantageous in particular in so far as the required measurement section can be shortened and the image field extent of the imaging system can thus also be reduced in comparison with linear arrangements in Fig. 4a. As is illustrated merely schematically in Fig. 5, the number of imaging paths (designated by "M" in Fig. 5) is incremented by one with each further folding.

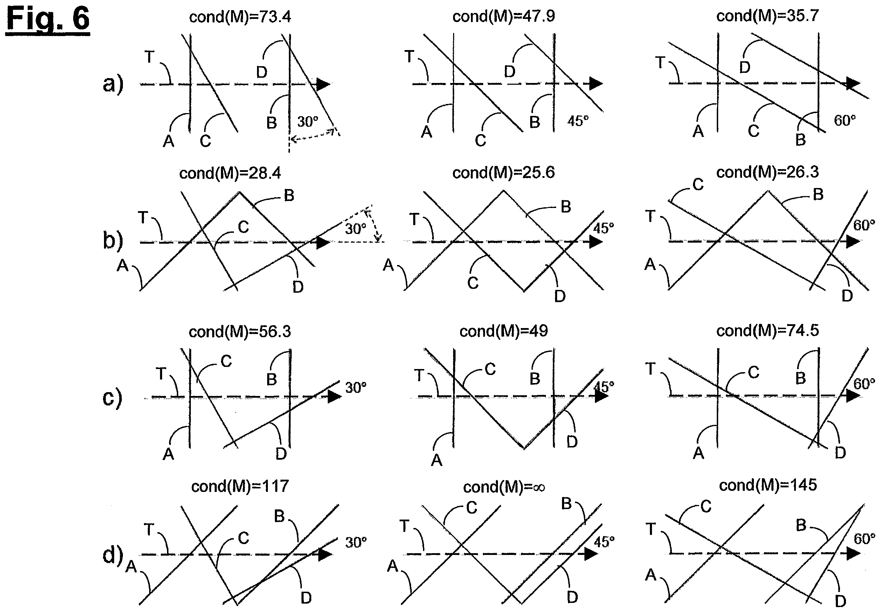

The number of photodetector cells is arbitrary in principle and can be increased e.g. in each case in order to measure higher-order flight trajectories (e.g. in the case of a parabolic flight or for a circular path measurement) and/or to improve the accuracy of the parameters by means of redundant measurements. Furthermore, the target line configuration, as described hereinafter below with reference to Fig. 6a-d, equation (8), can be optimized with regard to the condition number $cond(\underline{M})$ of the design matrix $\underline{M}$ from equation (8) above.

As explained below, the target line configuration on which the optoelectronic realization according to the invention is based can be selected or optimized in a suitable manner. This further aspect of the invention is based on the consideration that both the number and the geometrical arrangement of the target lines are crucial for the "quality" of the parameter reconstruction according to equation (8). As a measure of quality for the assessment of target line configurations, use is made hereinafter of the so-called "condition number" $cond(\underline{M})$ of the design matrix $\underline{M}$, which describes as it were the degree of mathematical definiteness or determinability of the set of parameters for the flight trajectory. The better the determinability of the set of parameters for the flight trajectory, the smaller the value of the condition number $cond(\underline{M})$. Without the invention being restricted thereto, hereinafter merely by way of example non-overdetermined minimal configurations with four target lines (K=4) are discussed, for which equation (8) assumes the following form.

$$\begin{pmatrix} x_0 \\ y_0 \\ u \\ v \end{pmatrix} = inv(\underline{M}) \begin{pmatrix} x_1 \\ x_2 \\ \vdots \\ x_K \end{pmatrix} \qquad (9)$$

In order to elucidate the assessment of different target line configurations, use is made of the illustrations in Fig. 6a-d, in each of which four target lines "A", "B", "C" and "D" are arranged in mutually different geometries and in which the flight trajectory or the trajectory (or generally the "centroid trajectory") is likewise depicted and designated by "T". The division of Fig. 6a-d into a first, second and third column is carried out on the basis of different orientation angles of the target line pair comprising the target lines "C" and "D". The condition number indicated corresponds to the mean value over the angle-of-incidence interval [-20° + 20°] around the centroid trajectory. In this case, "centroid trajectory" with the parameterization $(\overline{x}_0, \overline{y}_0, \overline{u}, \overline{v})$ should be understood to mean the trajectory lying in a centred manner in the parameter intervals limited on both sides, corresponding to

$$\overline{x}_0 = \frac{\max(x_0) + \min(x_0)}{2} \quad , \quad \overline{y}_0 = \frac{\max(y_0) + \min(y_0)}{2}$$

$$\overline{u} = \frac{\max(u) + \min(u)}{2} \quad , \quad \overline{v} = \frac{\max(v) + \min(v)}{2}$$

In detail, the target line configurations in Fig. 6a have pairwise parallel target lines comprising a pair perpendicular to the centroid trajectory, the target line configurations in Fig. 6b have pairwise perpendicular target lines comprising a pair in a 45° orientation with respect to the centroid trajectory, and the target line configurations in Fig. 6c have a pair of target lines oriented perpendicularly to the centroid trajectory and a pair of target lines perpendicular to one another. The target line configurations in Fig. 6d substantially correspond to those in Fig. 6c, wherein the target lines parallel to one another run at an angle of 45° with respect to the centroid trajectory. The following insights, in particular, can be read from Fig. 6:

- Not more than two target lines are permitted to run parallel to one another in the minimal configuration (the configuration having three parallel target lines in Fig. 6d, middle column, is underdetermined).

- The optimal configuration corresponds to the arrangement in the middle column of Fig. 6b, which has pairwise parallel target lines in the 45° and -45° orientation with respect to the centroid trajectory.

- The configurations in each case in the middle column of Fig. 6a and Fig. 6c having a pair of target lines perpendicular to the centroid trajectory hardly differ from one another in terms of the condition number and in this case are worse than the abovementioned optical configuration approximately by a factor of 2. One advantage of the arrangements in each case in the middle column of Fig. 6a and Fig. 6c, however, is that they optimally support the reduced problem with a known flight direction (along the x-axis).

As already mentioned, in the measuring arrangement according to the invention an imaging system is used to image the flying object situated in an object plane of the imaging system onto the photodetector arrangement situated in an image plane of the imaging system. Fig. 7a-b show merely by way of example schematic illustrations in each case of one possible imaging beam path realized within a measuring arrangement according to the invention.

The imaging system 700 in accordance with Fig. 7a has an object lens element group 710 in a Fourier configuration, a telescope 720 which is telecentric on both sides and in which an intermediate image is generated in an intermediate image plane designated by IMI, and an image lens element group 730 likewise in a Fourier configuration. The intermediate image plane IMI within the telescope 720 can be used to suppress undesired parasitic light and disturbing reflections with the aid of a stop. Three imaging beam paths that are representative of the three points $x_{obj} = 0$, $x_{obj} = +x$ and $x_{obj} = -x$ on the flight trajectory are indicated. The flight trajectory - running within the object plane OP in the x-direction in the coordinate system depicted - of the flying object (e.g. of a tin droplet attaining the plasma state in an EUV laser plasma source for microlithography) is imaged onto a photodetector arrangement 780 in a magnified manner by the imaging system 700. The photodetector arrangement 780 is unfolded in the exemplary embodiment in Fig. 7a and has four target lines.

As already explained, in the case of a photodetector arrangement having a folded target line arrangement, it is necessary for the imaging beam paths passing through the imaging system to be additionally replicated in a suitable manner. Fig. 7b shows a likewise merely exemplary construction of a replicating imaging system 750, wherein components that are analogous or substantially functionally identical in comparison with Fig. 7a are designated by reference numerals increased by "5".

The replication of the beam path in the imaging system 750 in Fig. 7b is effected with the use of the beam splitting principle by means of a diffractive grating and is thus suitable in particular for use in the case of sufficiently monochromatic light. The imaging system in Fig. 7b differs from that from Fig. 7a merely in that a diffractive structure 745 is inserted in the image-side pupil plane PP2. In order to realize a simple replication, use can be made, in particular, of a binary phase grating having a duty ratio of 1:1 and a phase deviation $\pi$, which concentrates e.g. in each case 41% of the light power into the first orders of diffraction and ideally completely or at least substantially eliminates the zero order.

In order to prevent the measurement result from being corrupted by a parasitic zero order of diffraction present e.g. on manufacturing defects, the photodetector arrangement 785, as indicated in Fig. 7b, is provided with a corresponding central zone between the two detection regions which cover the "used orders of diffraction" (i.e. the +1st and -1st orders of diffraction). The diffractive structure 745 or the grating for beam splitting is arranged in an accessible object- or image-side pupil plane. The orientation of the grating is chosen here preferably and as illustrated in Fig. 7b such that the splitting takes place perpendicularly to the centroid trajectory, that is to say takes place in the y-direction in the coordinate system depicted.

In further embodiments, the construction described with reference to Fig. 7b can also be extended to multiply folded multi-cell photodiodes (according to the scheme in Fig. 5). In this case, suitable design of the diffractive structure 745 or of the grating for beam splitting should ensure in each case that sufficiently identical intensities are concentrated in all used orders of diffraction.

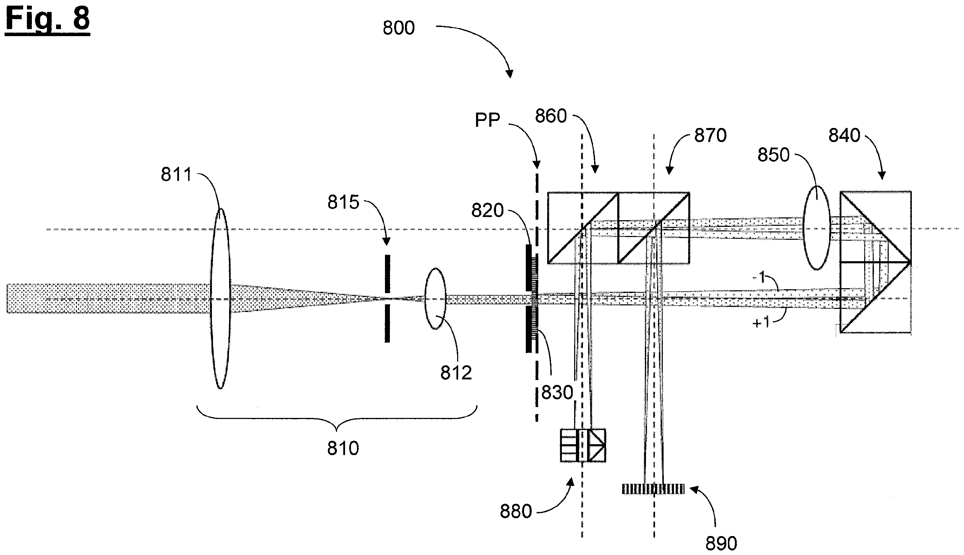

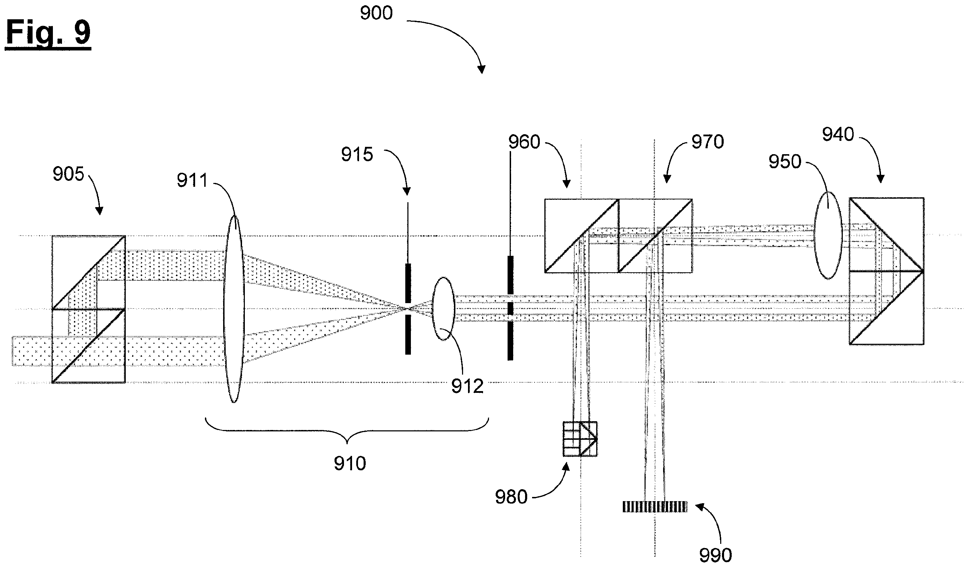

Embodiments which are suitable in each case in conjunction with a photodetector arrangement "constructed in a folded fashion" as described above will now be described below in each case with reference to Fig. 8 and 9.

Fig. 8 shows a schematic illustration for explaining the possible construction of a measuring arrangement according to the invention in one embodiment of the invention.

In accordance with Fig. 8, a parallel beam impinges on a first lens element 811 of a telescope 810. This beam is firstly focussed by this first lens element 811 and collimated again (with a reduced beam cross section in comparison with the original beam cross section prior to impinging on the first lens element 811) by a second lens element 812 of the telescope 810. A spatial filter 815 for eliminating undesired disturbing reflections, speckle patterns, etc. is situated between the lens elements 811, 812. Situated in a pupil plane PP downstream of the telescope 810 in the light propagation direction there are firstly an aperture stop 820 (for defining or restricting the numerical aperture) and then a grating 830 for splitting the incoming beam into two partial beams corresponding to the (+1)st and the (-1)st order of diffraction, in order to realize the folding described above. Downstream of a deflection mirror 840, these two beams of the (+1)st and (-1)st orders or diffraction impinge on a Fourier lens element 850, as a result of which the two beams are directed via deflection prisms 860 and respectively 870 onto a photodetector arrangement 880 and a camera 890. The photodetector arrangement 880 has a gap for the zero order of diffraction. The image recorded by the camera 890 can be used e.g. for alignment purposes.

Fig. 9 shows a schematic illustration for explaining a further possible embodiment of a measuring arrangement according to the invention, wherein in Fig. 9 components that are analogous or substantially functionally identical in comparison with the arrangement in Fig. 8 are designated by reference numerals increased by "100". The construction in Fig. 9 is based on the use of a beam splitter and takes account of the circumstance that the grating 830 used in the construction in Fig. 8 operates monochromatically, such that the construction in Fig. 8 is indeed suitable in the case of monochromatic light, but is less suitable for broadband light (owing to the chromatic aberration that then occurs on account of the grating 830).

In accordance with Fig. 9, a parallel beam impinging on the arrangement is firstly split into two partial beams by a beam splitter 905. The construction in Fig. 9 takes account of the circumstance that beam directing onto different sensors is prohibited owing to the high accuracy required. Rather, it is necessary to realize the imaging onto the folded photodetector arrangement 980 (in particular for instance in order to avoid scale differences) by means of a single optical unit. For this purpose, in accordance with Fig. 9, beam splitting takes place actually upstream of the telescope 910. The partial beams generated as a result run off-axis and with a parallel offset through the imaging system 900 in Fig. 9. The separation of the two partial beams (which otherwise converge to a common focus in the focal plane of the Fourier optical unit) is effected by the introduction of a relative tilting of the partial beams. For this purpose, either the beam splitter group as a whole and/or one of the two beam splitters forming said group can be tilted relative to the normal arrangement (90° and 45°).

Even though the invention has been described on the basis of specific embodiments, numerous variations and alternative embodiments are apparent to the person skilled in the art, e.g. by combination and/or exchange of features of individual embodiments. Accordingly, it goes without saying for the person skilled in the art that such variations and alternative embodiments are concomitantly encompassed by the present invention, and the scope of the invention is restricted only within the meaning of the appended patent claims.

## Claims

1. Measuring arrangement for use when determining trajectories of flying objects, wherein the measuring arrangement comprises:

   • at least one photodetector arrangement (411, 412, 421, 422, 780, 785, 880, 980) comprising a plurality of photodetector cells in a monolithic construction;
   • wherein said photodetector arrangement (411, 412, 421, 422, 780, 785, 880, 980) is assigned exactly one imaging system (700, 750, 800, 900), which, during the operation of the measuring arrangement, images in each case a flying object situated in an object plane (OP) of the imaging system onto the photodetector arrangement situated in an image plane (IP) of the imaging system; and
• a time measuring device for measuring transit instants, wherein each of said transit instants corresponds to an instant at which an image of a flying object, said image being generated in the image plane (IP) of the imaging system, in each case crosses a cell boundary between mutually adjacent photodetector cells in the photodetector arrangement (411, 412, 421, 422, 780, 785, 880, 980).

2. Measuring arrangement according to Claim 1, **characterized in that** the imaging system is configured as a replicating imaging system (750, 800, 900) which generates at least two images of the object in the image plane (IP).

3. Measuring arrangement according to Claim 1 or 2, **characterized in that** the imaging system (750, 800) has at least one diffractive structure (745, 830).

4. Measuring arrangement according to Claim 3, **characterized in that** the diffractive structure (745, 830) is arranged in a pupil plane of the imaging system (750, 800).

5. Measuring arrangement according to any of the preceding claims, **characterized in that** the imaging system (900) has at least one optical beam splitter (905).

6. Measuring arrangement according to any of the preceding claims, **characterized in that** the imaging system (750) has at least one intermediate image.

7. Measuring arrangement according to any of the preceding claims, **characterized in that** the photodetector cells are configured as photodiodes.

8. Measuring arrangement according to any of the preceding claims, **characterized in that** the photodetector arrangement is configured in such a way that at least one cell boundary between mutually adjacent photodetector cells runs, during operation of said measuring arrangement, at an angle of 45°±5° with respect to a centroid trajectory of a flying object.

9. Measuring arrangement according to any of the preceding claims, **characterized in that** the photodetector arrangement (411, 412, 421, 422, 780, 785, 880, 980) is configured in such a way that a first cell boundary between mutually adjacent photodetector cells and at least a second cell boundary between mutually adjacent photodetector cells run parallel to one another.

10. Measuring arrangement according to any of the preceding claims, **characterized in that** it is integrated into a control loop for controlling the trajectories of flying objects, for controlling a radiation field acting on the objects and/or for controlling an entity acting on the objects.

11. Measuring arrangement according to any of the preceding claims, **characterized in that** it furthermore comprises at least one camera (890, 990) in the imaging beam path of the imaging system (800, 900).

12. Measuring arrangement according to any of the preceding claims, **characterized in that** it comprises at least two imaging systems (700, 750, 800, 900), wherein a photodetector arrangement (411, 412, 421, 422, 780, 785, 880, 980) comprising in each case a plurality of photodetector cells in a monolithic construction is in each case arranged in the image plane (IP) of each of said imaging systems.

13. Measuring arrangement according to any of the preceding claims, **characterized in that** it is configured for use when determining trajectories of target droplets of a laser plasma source, in particular of an EUV source of a microlithographic projection exposure apparatus.

**Patentansprüche**

1. Messanordnung zur Verwendung beim Bestimmen von Trajektorien von Flugobjekten, wobei die Messanordnung aufweist:

   • mindestens eine Fotodetektoranordnung (411, 412, 421, 422, 780, 785, 880, 980), die mehrere Fotodetektorzellen in einer monolithischen Bauweise aufweist;

• wobei die Fotodetektoranordnung (411, 412, 421, 422, 780, 785, 880, 980) genau einem Bildgebungssystem (700, 750, 800, 900) zugewiesen ist, das während des Betriebs der Messanordnung in jedem Fall ein Flugobjekt, das sich in einer Objektebene (OP) des Bildgebungssystems befindet, auf die Fotodetektoranordnung, die sich in einer Bildebene (IP) des Bildgebungssystems befindet, abbildet; und

• eine Zeitmessvorrichtung zum Messen von Übergangsmomenten, wobei jeder der Übergangsmomente einem Moment entspricht, in dem ein Bild eines Flugobjekts in jedem Fall eine Zellengrenze zwischen aneinander angrenzenden Fotodetektorzellen in der Fotodetektoranordnung (411, 412, 421, 422, 780, 785, 880, 980) kreuzt, wobei das Bild in der Bildebene (IP) des Bildgebungssystems erzeugt wird.

2. Messanordnung nach Anspruch 1, **dadurch gekennzeichnet, dass** das Bildgebungssystem als ein replizierendes Bildgebungssystem (750, 800, 900) konfiguriert ist, das mindestens zwei Bilder des Objekts in der Bildebene (IP) erzeugt.

3. Messanordnung nach Anspruch 1 oder 2, **dadurch gekennzeichnet, dass** das Bildgebungssystem (750, 800) mindestens eine lichtbrechende Struktur (745, 830) aufweist.

4. Messanordnung nach Anspruch 3, **dadurch gekennzeichnet, dass** die lichtbrechende Struktur (745, 830) in einer Pupillenebene des Bildgebungssystems (750, 800) angeordnet ist.

5. Messanordnung nach einem der vorstehenden Ansprüche, **dadurch gekennzeichnet, dass** das Bildgebungssystem (900) mindestens einen optischen Strahlenteiler (905) aufweist.

6. Messanordnung nach einem der vorstehenden Ansprüche, **dadurch gekennzeichnet, dass** das Bildgebungssystem (750) mindestens ein Zwischenbild aufweist.

7. Messanordnung nach einem der vorstehenden Ansprüche, **dadurch gekennzeichnet, dass** die Fotodetektorzellen als Fotodioden konfiguriert sind.

8. Messanordnung nach einem der vorstehenden Ansprüche, **dadurch gekennzeichnet, dass** die Fotodetektoranordnung derart konfiguriert ist, dass mindestens eine Zellengrenze zwischen aneinander angrenzenden Fotodetektorzellen während des Betriebs der Messanordnung in einem Winkel von 45° $\pm$ 5° in Bezug auf eine Schwerpunkttrajektorie eines Flugobjekts verläuft.

9. Messanordnung nach einem der vorstehenden Ansprüche, **dadurch gekennzeichnet, dass** die Fotodetektoranordnung (411, 412, 421, 422, 780, 785, 880, 980) derart konfiguriert ist, dass eine erste Zellengrenze zwischen aneinander angrenzenden Fotodetektorzellen und mindestens eine zweite Zellengrenze zwischen aneinander angrenzenden Fotodetektorzellen parallel zueinander verlaufen.

10. Messanordnung nach einem der vorstehenden Ansprüche, **dadurch gekennzeichnet, dass** sie in einen Regelkreis zum Regeln der Trajektorien von Flugobjekten integriert ist, um ein Strahlenfeld zu regeln, das auf die Objekte einwirkt, und/oder um eine Entität zu regeln, die auf die Objekte einwirkt.

11. Messanordnung nach einem der vorstehenden Ansprüche, **dadurch gekennzeichnet, dass** sie des Weiteren mindestens eine Kamera (890, 990) im Bildgebungsstrahlengang des Bildgebungssystems (800, 900) aufweist.

12. Messanordnung nach einem der vorstehenden Ansprüche, **dadurch gekennzeichnet, dass** sie mindestens zwei Bildgebungssysteme (700, 750, 800, 900) aufweist, wobei eine Fotodetektoranordnung (411, 412, 421, 422, 780, 785, 880, 980), die in jedem Fall mehrere Fotodetektorzellen in einer monolithischen Bauweise aufweist, in jedem Fall in der Bildebene (IP) von jedem von den Bildgebungssystemen angeordnet ist.

13. Messanordnung nach einem der vorstehenden Ansprüche, **dadurch gekennzeichnet, dass** sie zur Verwendung beim Bestimmen von Trajektorien von Zieltröpfchen einer Laserplasmaquelle und insbesondere einer EUV-Quelle einer mikrolithografischen Projektionsbelichtungsvorrichtung konfiguriert ist.

**Revendications**

1. Arrangement de mesure destiné à être utilisé lors de la détermination des trajectoires d'objets volants, l'arrangement de mesure comprenant :

* au moins un arrangement photodétecteur (411, 412, 421, 422, 780, 785, 880, 980) comprenant une pluralité de cellules de photodétection en une construction monolithique ;

* exactement un système d'imagerie (700, 750, 800, 900) étant attribué audit arrangement photodétecteur (411, 412, 421, 422, 780, 785, 880, 980), lequel système d'imagerie, pendant le fonctionnement de l'arrangement de mesure, représente dans chaque cas des images d'un objet volant situé dans un plan d'objet (OP) du système d'imagerie sur l'arrangement photodétecteur situé dans un plan d'image (IP) du système d'imagerie ; et

* un dispositif de mesure du temps destiné à mesurer des instants de transit, chacun desdits instants de transit correspondant à un instant auquel une image d'un objet volant, ladite image étant générée dans le plan d'image (IP) du système d'imagerie, croise dans chaque cas une limite de cellule entre des cellules de photodétecteur mutuellement voisines dans l'arrangement photodétecteur (411, 412, 421, 422, 780, 785, 880, 980) .

2. Arrangement de mesure selon la revendication 1, **caractérisé en ce que** le système d'imagerie est configuré sous la forme d'un système d'imagerie à réplication (750, 800, 900) qui génère au moins deux images de l'objet dans le plan d'image (IP).

3. Arrangement de mesure selon la revendication 1 ou 2, **caractérisé en ce que** le système d'imagerie (750, 800) comporte au moins une structure diffractive (745, 830) .

4. Arrangement de mesure selon la revendication 3, **caractérisé en ce que** la structure diffractive (745, 830) est disposée dans un plan pupillaire du système d'imagerie (750, 800) .

5. Arrangement de mesure selon l'une quelconque des revendications précédentes, **caractérisé en ce que** le système d'imagerie (900) comprend au moins un diviseur de faisceau optique (905).

6. Arrangement de mesure selon l'une quelconque des revendications précédentes, **caractérisé en ce que** le système d'imagerie (750) comprend au moins une image intermédiaire.

7. Arrangement de mesure selon l'une quelconque des revendications précédentes, **caractérisé en ce que** les cellules de photodétection sont configurées sous la forme de photodiodes.

8. Arrangement de mesure selon l'une quelconque des revendications précédentes, **caractérisé en ce que** l'arrangement photodétecteur est configuré de telle sorte qu'au moins une limite de cellule entre des cellules de photodétection mutuellement voisines, pendant le fonctionnement dudit arrangement de mesure, s'étend en formant un angle de 45° ± 5° par rapport à une trajectoire de centroïde d'un objet volant.

9. Arrangement de mesure selon l'une quelconque des revendications précédentes, **caractérisé en ce que** l'arrangement photodétecteur (411, 412, 421, 422, 780, 785, 880, 980) est configuré de telle sorte qu'une première limite de cellule entre des cellules de photodétection mutuellement voisines et au moins une deuxième limite de cellule entre des cellules de photodétection mutuellement voisines s'étendent parallèlement l'une à l'autre.

10. Arrangement de mesure selon l'une quelconque des revendications précédentes, **caractérisé en ce qu'**il est intégré dans une boucle de régulation pour commander les trajectoires d'objets volants, pour commander un champ de rayonnement agissant sur les objets et/ou pour commander une entité qui agit sur les objets.

11. Arrangement de mesure selon l'une quelconque des revendications précédentes, **caractérisé en ce qu'**il comprend en outre au moins un appareil photographique (890, 990) dans le trajet du faisceau de capture d'image du système d'imagerie (800, 900).

12. Arrangement de mesure selon l'une quelconque des revendications précédentes, **caractérisé en ce qu'**il comprend au moins deux systèmes d'imagerie (700, 750, 800, 900), un arrangement photodétecteur (411, 412, 421, 422, 780, 785, 880, 980) comprenant dans chaque cas une pluralité de cellules de photodétection en une construction monolithique étant, dans chaque cas, disposé dans le plan d'image (IP) de chacun desdits systèmes d'imagerie.

13. Arrangement de mesure selon l'une quelconque des revendications précédentes, **caractérisé en ce qu'**il est configuré pour être utilisé lors de la détermination des trajectoires de gouttelettes cibles d'une source de plasma à laser, notamment d'une source d'EUV d'un appareil d'exposition de projection microlithographique.

**Fig. 1**

**Fig. 2**

a)

200

201

202

205

b)

c)

$s_1(x)$ $s_2(x)$

d) $\dfrac{s_1(x) - s_2(x)}{s_1(x) + s_2(x)}$

**Fig. 3**

205

0-event

220

$t_1 - t_0$

210

EP 3 074 820 B1

Fig. 4

EP 3 074 820 B1

Fig. 5

**Fig. 6**

cond(M)=73.4  cond(M)=47.9  cond(M)=35.7

a)

cond(M)=28.4  cond(M)=25.6  cond(M)=26.3

b)

cond(M)=56.3  cond(M)=49  cond(M)=74.5

c)

cond(M)=117  cond(M)=∞  cond(M)=145

d)

EP 3 074 820 B1

**Fig.7a**

**Fig. 7b**

Fig. 8

800

PP

860

870

840

811

815

850

820

812

830

810

-1
+1

880

890

EP 3 074 820 B1

EP 3 074 820 B1

**Fig. 9**

# Fig. 10

EP 3 074 820 B1

**EP 3 074 820 B1**

REFERENCES CITED IN THE DESCRIPTION

**Patent documents cited in the description**

- US 2010258747 A1
- US 2012104289 A
- DE 102012006529 A1